# EUROPEAN PATENT SPECIFICATION

(11) **EP 1 642 174 B1**
(45) Date of publication and mention of the grant of the patent: **17.09.2008**
(21) Application number: 04746752.7
(22) Date of filing: 24.06.2004
(51) Int. Cl.: G03F 7/20, G03F 1/14

(54) **EXPOSURE METHOD AND APPARATUS, EXPOSURE MASK, AND DEVICE MANUFACTURING METHOD**
BELICHTUNGSVERFAHREN UND VORRICHTUNG, BELICHTUNGSMASKE UND HERSTELLUNGSVERFAHREN
PROCEDE ET APPAREIL D'EXPOSITION, MASQUE D'EXPOSITION ET PROCEDE DE FABRICATION D'UN DISPOSITIF

(30) Priority: 24.06.2003 JP 2003179587; 30.03.2004 JP 2004097983
(43) Date of publication of application: 05.04.2006
(73) Proprietor: CANON KABUSHIKI KAISHA, Ohta-ku Tokyo 146-8501 (JP)
(72) Inventor: KURODA, Ryo, Kawasaki-shi, Kanagawa 214-0012 (JP); MIZUTANI, Natsuhiko, Tokyo 113-0022 (JP); YAMADA, Tomohiro, Yokohama-shi, Kanagawa-ken (JP)
(74) Representative: TBK-Patent
(86) International application number: PCT/JP2004/009283
(87) International publication number: WO 2004/114024

(56) References cited:
- EP-A- 1 008 870
- WO-A-03/016781
- WO-A-03/019245
- WO-A-03/042748
- US-A- 5 973 316
- BLAIKIE R J ET AL: "EVANESCENT INTERFEROMETRIC LITHOGRAPHY" APPLIED OPTICS, OPTICAL SOCIETY OF AMERICA,WASHINGTON, US, vol. 40, no. 10, 1 April 2001 (2001-04-01), pages 1692-1698, XP001066000 ISSN: 0003-6935

## Description

This invention relates to an exposure method and apparatus, an exposure mask, and a device manufacturing method.

Increasing capacity of a semiconductor memory and increasing speed and density of a CPU processor have inevitably necessitated further improvements in fineness of microprocessing through optical lithography. Generally, the limit of microprocessing with an optical lithographic apparatus is of an order of the wavelength of light used. Thus, the wavelength of light used in optical lithographic apparatuses haven been shortened more and more. Currently, near ultraviolet laser is used, and microprocessing of 0.1 µm order is enabled. While the fineness is being improved in the optical lithography, in order to assure microprocessing of 0.1 µm or narrower, there still remain many unsolved problems such as further shortening of laser, development of lenses usable in such wavelength region, and the like.

On the other hand, as a measure for enabling microprocessing of 0.1 µm or narrower, a microprocessing apparatus using a structure of a near-field optical microscope (scanning near-field optical microscope: SNOM), has been proposed. An example is an exposure apparatus in which, by use of near field light leaking from a fine opening of a size not greater than 100 nm, local exposure that exceeds the light wavelength limit is performed to a resist.

However, since such lithographic apparatus with an SNOM structure is arranged to execute the microprocessing by use of one or more processing probes, as like continuous drawing. Thus, there is a problem that the throughput is not high. As one method for solving such problem, U.S. Patent No. 6,171,730 proposes exposure technology using a near-field mask, wherein light is projected to a rear surface of an optical mask having an opening pattern of a size not greater than 0.1 µm, formed in a light blocking film, and, by using near field light leaking from this opening pattern, a pattern of the optical mask is transferred to a resist at once.

The method and apparatus disclosed in the aforementioned U.S. patent is very useful and it makes a large contribution to the technical field to which the present invention pertains.

In the exposure method using a near-field mask as disclosed in the aforementioned U.S. patent, the near field light leaking from the opening pattern of the mask has a distribution being expanded in omni-direction from the exit side edge of the opening. Therefore, as the distance between an opening pattern and another opening pattern becomes closer, near field lights leaking from the adjacent opening patterns may be superposed one another, thereby causing a limit of exposure resolution.

Document WO 03/042748 A1 discloses surface plasmon optic devices and radiating surface plasmon sources for photolithography. The surface plasmon optic device has a periodic array of apertures in a dielectric substrate and a metal film formed on the dielectric substrate and emits light from metal-air interface. The surface plasmon optic device includes a surface plasmon generating apparatus, a surface plasmon detecting apparatus, a surface plasmon controlling apparatus, an etching apparatus, etc. if a metal diffraction grating is disposed on the metal film having a well-defined interface, propagation of the surface plasmon can be efficiently reflected, divided and controlled. Further, radiating surface plasmon having a half period of a lattice constant formed at air-metal can be preserved at a distance of at least a few micron.

Further, document WO 03/016781 A2 discloses a surface plasmon enhanced illumination system. The methods and apparatus for producing small, bright nanometric light sources from apertures are smaller than the wavelength of the emitted light. Light is directed at a surface layer of metal onto a light barrier structure that includes one or more apertures each of which directs a small spot of light onto a target. The incident light excites surface plasmons (electron density fluctuations) in the top metal surface layer and this energy couples through the apertures to the opposing surface where it is emitted as light from the apertures of from the rims of the apertures. Means are employed to prevent or severely limit the extent to which surface plasmons are induced on the surface at the aperture exit, thereby constraining the resulting emissions to small target areas. The resulting small spot illumination may be used to increase the resolution of microscopes and photolithographic processes, increase the storage capacity and performance of optical data storage systems, and analyze the properties of small objects such as protein and nucleic acid molecules and single cells.

It is an object of the present invention to provide an exposure method and apparatus, an exposure mask and a device manufacturing method, by which, in an exposure process using a near field mask, superposition of near field lights leaking from adjacent openings of the mask can be avoided such that high resolution exposure is assured.

The present invention provides an exposure method and apparatus, an exposure mask, and a device manufacturing method according to what is set forth in the appended claims.

Here, it should be noted that, in the present invention, the portion where the light intensity is decreased by mutual interference of surface plasmon polariton waves includes a portion in which the light intensity is approximately equal to zero.

In accordance with the present invention, even if the spacing between adjacent openings is close to the wavelength of light or shorter, there is no possibility that near field lights leaking from the adjacent openings of the mask are superposed one upon another. Thus, the present invention can achieve an exposure method and apparatus, an exposure mask and a device manufacturing method by which high resolution exposure is attainable.

The end portion of the opening of the mask, at the side close to the exposure object to be exposed, is structured so as to reduce H scatter of surface plasmon polariton wave and, in that occasion, a near-field exposure mask by which the contrast can be improved furthermore is accomplished.

These and other objects, features and advantages of the present invention will become more apparent upon a consideration of the following description of the preferred embodiments of the present invention taken in conjunction with the accompanying drawings.
Figure 1A and 1B are schematic views, respectively, for explaining a general structure of a near-field exposure mask.
Figure 2 is a schematic view for explaining the structure and operation of a near-field mask exposure apparatus.
Figure 3 is a sectional view for explaining the principle of near field exposure.
Figures 4A - 4E are schematic views, respectively, for explaining the procedure for making a near-field exposure mask.
Figure 5 is a sectional view for explaining the principle of near field exposure method according to the present invention.
Figures 6A and 6B are illustrations for explaining the relation between the light intensity and the distance z from a first surface of a metal thin film.
Figure 7 is a sectional view for explaining reduced scatter of SPP (surface plasmon polariton) wave, at an opening having an exit-side edge portion with a curved surface structure.
Figures 8A - 8C' are schematic views, respectively, illustrating examples of resist patterns which are obtainable from masks having a two-dimensional shape pattern, wherein Figure 8A and 8A' are a case where a mask pattern having a grid-like fine openings is used, wherein Figures 8B and 8B' are a case where a mask having a two-dimensional fine opening array is used, and wherein Figures 8C and 8C' are a case wherein a mask whose light blocking metal film has a two-dimensional rectangular array is used.
Figures 9A and 9B are schematic views, respectively, showing a mask having a light blocking metal film of a two-dimensional ring-like shaped pattern as well as a resist pattern obtainable from that mask.

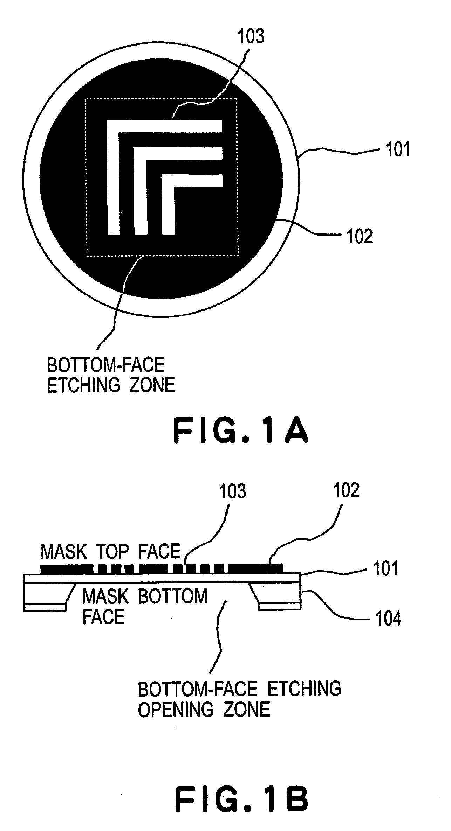

Referring to Figures 1A and 1B, the structure and function of a near-field exposure mask to be used in a near-field exposure method will be described.

Figures 1A and 1B illustrate the structure of a near-field exposure mask, wherein Figure 1A is a plan view as seen from a front surface side of the mask, and Figure 1B is a sectional view.

As shown in Figures 1A and 1B, the near-field exposure mask comprises a mask base material 101 which is provided by a thin film of a film thickness of 0.1 to 100 µm and which is transparent with respect to light of the exposure wavelength. A metal thin film 102 of a film thickness of about 50 - 100 nm, that constitutes a light blocking film, is provided on the mask base material 101. The metal thin film 102 is formed with a fine opening pattern 103 of a width not greater than 100 nm. The mask base material 101 is supported by a substrate 104.

If the thickness of the mask base material 101 is smaller, elastic deformation is easily caused and thus the base material can elastically deform to follow even small surface irregularity or waviness of the resist and substrate surface. Therefore, the adhesion is improved thereby. However, if the thickness is too small relative to the exposure area, the strength as a mask becomes insufficient, or it causes a possibility that, when the base material is going to be peeled off after intimate contact and exposure, it is broken due to an adhesion force acting on between the resist and the substrate.

Thus, from the standpoint of mechanical property, the thickness of the mask base material 101 should desirably be in the range of 0.1 - 100 µm.

As regards the material for the mask base material 101, those that can be formed into a thin film with good precision with respect to shape, that is, film thickness or surface roughness, for example, and that have small distortion in transverse directions along its plane when formed into a thin film. From this standpoint, Si₃N₄, SiO₂, and Si are preferable.

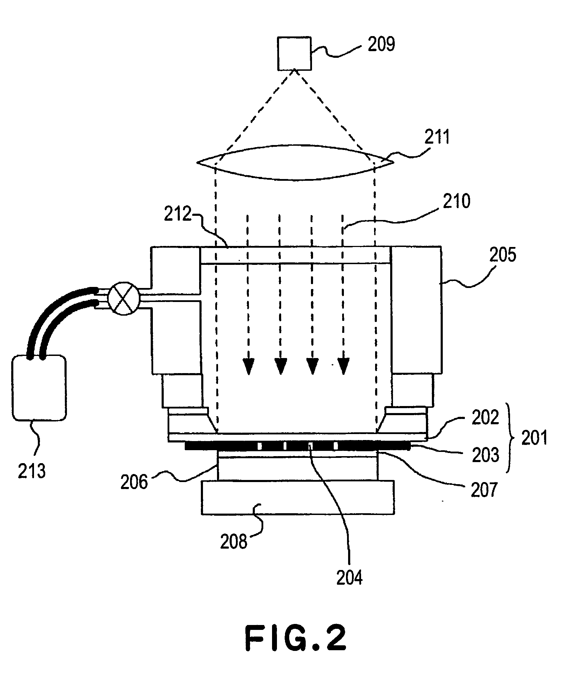

Referring to Figure 2, the structure and operation of a near-field mask exposure apparatus will be described.

Denoted in Figure 2 at 201 is a near-field exposure mask. The near-field exposure mask 201 comprises a mask base material 202 and a metal thin film 203. The metal thin film 203 is provided on the mask base material 202, and the metal thin film 203 is formed with a fine opening pattern 204. The mask 201 is disposed so that its front surface (lower surface in Figure 2) faces the outside of a pressure adjusting vessel 205 while its rear surface (upper surface in Figure 2) faces the inside of the pressure adjusting vessel 205. The pressure adjusting vessel 205 is arranged so that the inside pressure thereof is adjustable.

Here, a substrate 206 having a resist 207 formed on its surface is an exposure object (that is, an object to be exposed). The resist 207 and the substrate 206 are mounted on a stage 208, and, by moving the stage 208, relative alignment of the substrate 206 with respect to the near-field exposure mask 201 in regard to two-dimensional directions along the mask surface is carried out. Subsequently, the stage 208 is moved in a direction of a normal to the mask surface so as to bring the front surface of the near-field exposure mask 201 and the resist 207 surface of the substrate 206 into intimate contact with each other so that, throughout the surface, the clearance between the front surface of the exposure mask 201 and the resist 207 surface of the substrate is kept at 100 nm or less.

Next, the manner how to assure intimate contact between the near-field exposure mask and the resist and substrate will be described in detail.

If the front surface of the near-field exposure mask 201 and the resist 207 surface on the substrate 206 are completely flat, they can be brought into intimate contact with each other throughout the entire surface. Actually, however, the mask surface or the resist and substrate surface has a surface irregularity or surface waviness. Therefore, only by approximating them toward each other and bringing them into contact with each other, the result would be mixed distribution of intimate contact portions and non-intimate contact portions.

In consideration of it, a pressure is applied to the near-field exposure mask 201 from it rear surface side to the front surface side to cause flexure of the mask 201 due to elastic deformation thereof, to thereby press the mask against the resist 207 and the substrate 206. By doing so, the mask and the resist and substrate can be intimately contacted to each other, throughout the entire surface.

As an example of such pressure application method, as shown in Figure 2, the near-field exposure mask 201 is disposed so that its front surface faces the outside of the pressure adjusting vessel 205 while its rear surface faces the inside of the pressure adjusting vessel 205. Also, by using pressure adjusting means 213 such as a pump, for example, a high pressure gas is introduced into the pressure adjusting vessel to ensure that the inside pressure of the pressure adjusting vessel becomes higher than the outside atmospheric pressure.

As an alternative example, the inside of the pressure adjusting vessel 205 may be filled with a liquid which is transparent with respect to the exposure light and, by using a cylinder, the pressure of the liquid inside the pressure adjusting vessel 205 may be adjusted.

In this embodiment, for pressure application, a high pressure gas is introduced into the pressure adjusting vessel 205 to increase the inside pressure of the vessel 205, such that the front surface of the near-field exposure mask 201 and the resist 207 surface on the substrate 206 are brought into intimate contact with each other throughout the entire surface, with uniform pressure.

Where pressure application is performed in the manner described above, in accordance with the Pascal's principle the repulsive force acting on between the front surface of the mask 201 and the resist 207 surface of the substrate 206 becomes uniform. This effectively avoids a phenomenon that a large force is locally applied to the mask 201 or the resist 207 surface of the substrate 206, and thus it effectively prevents local breakage of the mask 201, the substrate 206 or the resist 207.

Here, by adjusting the inside pressure of the pressure adjusting vessel 205, the pressing force to be applied to between the mask 201 and the resist 207 and substrate 206, that is, the adhesion strength of them, can be controlled. For example, if the mask surface or resist and substrate surface have slightly large surface irregularities or waviness, the inside pressure of the pressure adjusting vessel may be set at a higher level to increase the adhesion strength, thereby to reduce dispersion of clearance between the mask surface and the resist and substrate surface due to the surface irregularities or waviness.

The foregoing description has been made to an example wherein, for intimate contact between the mask and the resist/substrate, the rear surface of the near-field exposure mask is placed inside the pressurizing vessel and, on the basis of a pressure difference with the atmospheric pressure, lower than the vessel inside pressure, a pressure is applied from the rear surface side of the mask to the front surface side. However, as a reversed structure, the front surface of a near-field mask as well as a resist and a substrate may be disposed inside a reduced-pressure vessel and, on the basis of a pressure difference with the atmospheric pressure, higher than the vessel inside pressure, a pressure may be applied to the mask from its rear surface side to its front surface side. Anyway, such pressure difference that the pressure at the rear surface side of the near-field exposure mask is higher than the pressure at the front surface side, is produced.

In the manner described above, the near-field exposure mask 201 and the resist 207 surface are brought into intimate contact with each other, up to a near field exposure region. After this, exposure light 210 emitted from an exposure light source 209 and transformed into parallel light by means of a collimator lens 211 is introduced into the pressure adjusting vessel 205 through a glass window 212, and it illuminates the exposure mask 201 from its rear surface (upper surface in Figure 2). Thus, the resist 207 is exposed with near field light leaking from the fine opening pattern 204 formed in the metal thin film 203 upon the mask base material 202, which is at the front surface of the exposure mask 201.

Here, as regards the material of the resist 207, photoresist materials used in ordinary semiconductor process may be chosen. While the wavelength of light effective to such resist materials is generally within the range of 200 - 500 nm, if photoresist materials that can meet g-line or i-line in the range of 350 - 450 nm are chosen, the process freedom would become high and the cost would be reduced because there are many such materials available and yet they are inexpensive.

Regarding these photoresist materials, each material has an exposure sensitivity Eth (i.e. a threshold value related to the exposure) corresponding to the film thickness and exposure wavelength. By applying a light quantity equal to ore more than the exposure sensitivity Eth, the exposure is carried out. In the near-field exposure apparatus of the present invention, the resist film thickness should desirably be not greater than 100 nm, to be described later. The exposure sensitivity Eth where such photoresist is used with a film thickness of not greater than 100 nm is, generally, in the range of 5 - 50 mJ/cm².

As regards the exposure light source 209, it is necessary to use a light source that can emit light of a wavelength with which a used resist 207 can be exposed. For example, where a photoresist that can meet i-line or g-line as described above is used as the resist 207, HeCd laser (wavelength is 325 nm or 442 nm), GaN series blue semiconductor laser (wavelength is 410 nm or shorter), second harmonic generation (SHG) laser or third harmonic generation (THG) laser of infrared laser, or Hg lamp (436 nm (g-line) or 365 nm (i-line)) may be used.

By adjusting a driving voltage and an electric current as well as the irradiation time of the exposure light source 209, the exposure light quantity can be adjusted. For example, if a beam from a HeCd laser, having a beam diameter of 1 mm and a light output of 100 mW, is expanded into a zone of 100 mm x 100 mm by means of a beam extender or a collimator lens, the optical power per unit area becomes equal to 1 mW/cm². If such light is projected onto the resist surface for ten seconds, the exposure light quantity of the resist is 10 mJ/cm². If this value is greater than the aforementioned resist exposure sensitivity Eth, the exposure is accomplished. Actually, since the light irradiation is carried out while the near-field exposure mask is sandwiched, the light power adjustment is necessary, taking into account the transmissivity of the mask.

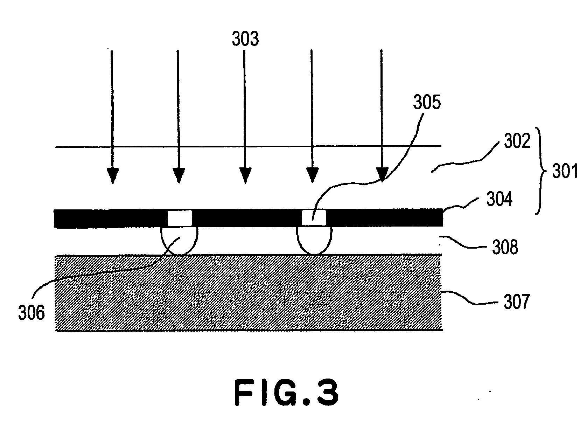

Referring now to Figure 3, the principle of exposure based on near field light will be explained.

In Figure 3, incident light 303 projected on a mask base material 302 that constitutes a near-field exposure mask 301, illuminates a fine opening pattern 305 formed in a metal thin film 304. Here, the size (width) of the fine opening pattern 305 is small as compared with the wavelength of the incident light 303, and it is not greater than 100 nm.

Generally, light could hardly pass through an opening of a size smaller than its wavelength. However, adjacent the opening, there is a small amount of leaked light 306, called near field light. This light is non-propagation light being present only adjacent the opening, within a distance not greater than about 100 nm. It has a property that, as coming away from the opening, the intensity thereof decreases suddenly. Taking this into account, the surface of a resist 308 formed on a substrate 307 is approximated to a distance not greater than 100 nm. Then, the near field light 306 is scattered within the resist 308 and transformed into propagation light, such that the resist 308 is exposed.

Here, if the metal thin film 304 is formed with a thickness of about 100 nm, direct transmission of incident light 303 which otherwise passes through a portion of the metal thin film 304, other than the pattern portion where the fine opening pattern 305 is formed, can be blocked approximately completely by 100%. Thus, it is possible to prevent exposure of the resist 308 surface, other than the portion opposed to the fine opening pattern 305 area.

However, in order to produce a pattern yet having a smaller linewidth, it is necessary to make the opening width of the fine opening pattern 305 smaller, namely, to make larger the aspect ratio of the fine opening pattern 305 (i.e. the ratio of "film thickness of the metal thin film 304" divided by "opening width of the fine opening pattern 305").

In an exposure method that uses near field light 306 leaking from a fine opening pattern 305, as described with reference to this embodiment, the quantity of near field light 306 decreases as the opening width of the fine opening pattern 305 becomes smaller. Also, even for the same opening width, the quantity of near field light 306 decreases, with larger the film thickness of the metal thin film 304 is. This is because leakage of near field light becomes difficult as the length of the path having a width narrower than the wavelength of the light becomes longer. For these reasons, where the opening width of the fine opening pattern 305 is narrowed, the exposure time should be prolonged.

Where the resist 308 film thickness is sufficiently thin, the scatter of the near field light within the resist 308 does not expand largely in (transverse) directions along the surface, such that a latent image of a fine opening pattern corresponding to the fine opening pattern 305 of a size smaller than the wavelength of the incident light 303 can be formed in and transferred to the resist.

After the exposure based on near field light is carried out in this manner, the substrate 307 is processed through ordinary processes. For example, the resist is developed and, thereafter, an etching process is performed. Through these processes, a fine pattern corresponding to the fine opening pattern described above can be produced upon the substrate 307.

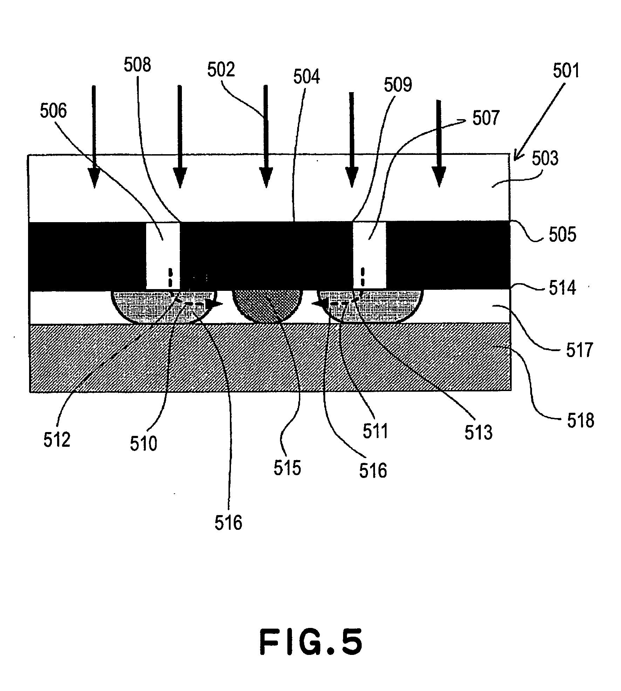

Next, referring to Figure 5, the principle of the near field exposure method of the present invention will be described in detail. Since the near field light leaking from an opening has a distribution, being expanded in omni-direction from the light exit side edge of the opening. If, therefore, the spacing between adjacent openings is small, due to lateral expansion of the near field light leaked from the opening, the near field lights leaking from adjacent opening patterns may be superposed one upon another. In that occasion, the resolution of exposure would be degraded.

However, in accordance with the findings acquired by the inventors of the present invention through precise photoelectric field analysis, it has been found that, in Figure 5, when incident light 502 for exposure is incident on a near-field exposure mask 501, at a second surface 505 (corresponding to the interface between a mask base material 503 and a light blocking metal film 504) the incident light 502 irradiates light entrance side edge portions 508 and 509 of the openings 506 and 507, respectively, and, as a result of it, surface plasmon polariton waves (SPP waves) 510 and 511 are produced.

The SPP wave can be propagated along the inside surface of the opening of the light blocking metal film as a transverse wave wherein electric charges oscillate in a direction perpendicular to the inside surface of the opening. At the light exit side edge portion 512 (513) of the opening, a portion of the SPP wave is scattered and transformed into propagation light. The remaining portion of the light goes around to a first surface 514 side (corresponding to the interface between a resist 517 and the light blocking metal film 504) as depicted by broken-line arrows in Figure 5, and it is propagated along that surface. Here, the SSP wave 510 coming around from the left-hand side opening 506 and the SPP wave 511 coming around from the right-hand side opening 507 have mutually opposite oscillation directions (i.e. opposite phases). Therefore, these waves interfere with each other at a position approximately at the middle between adjacent openings, on the first surface 514. As a result of this, a portion 515 (broken-line region in Figure 5) having a light intensity approximately equal to zero is produced. As regards the portion 515 having an approximately zero light intensity, even if the spacing between adjacent openings is smaller, it surely exists at a position approximately at the middle between the openings, on the first surface 514, though its region diminishes to become closer to the opening, as viewed in the drawing.

Therefore, by producing such an optical latent image in the resist 517 that corresponds to a difference in contrast between (i) a portion 516, adjacent the opening at the first surface 514, where the light intensity has a certain finite value and (ii) the portion 515 where the light intensity is approximately equal to zero, the resolution of exposure can be improved significantly even if the spacing between adjacent openings is made small. In Figure 5, a substrate 518 is a member to which a pattern formed on the resist 571 in the manner described above is to be transferred.

The wording "a portion having a light intensity approximately equal to zero" does not limitedly mean a zone where the intensity is exactly zero, but it involves a range, including a zone having a reduced light intensity.

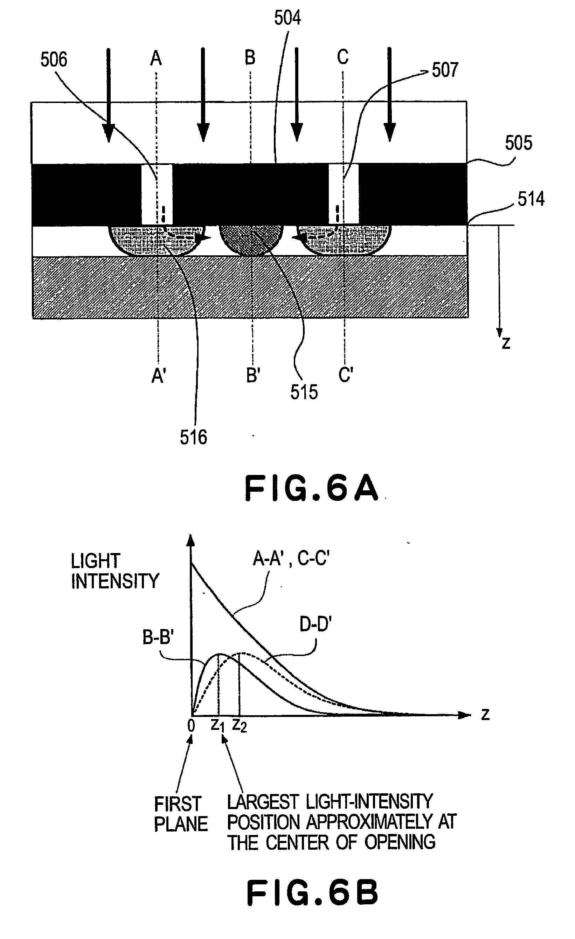

Figures 6A and 6B illustrate the relationship of the light intensity at the opening (line A-A' and line C-C') and at an approximately middle position (line B-B') between openings, versus the distance z from the first surface of the light blocking metal film.

At the opening portion A-A' or C-C', as coming away from the position z=0 (i.e. first surface), the light intensity is attenuated monotonously. This is because of the property that the intensity of near field light decreases suddenly as becoming away from the opening, and also, since the near field light and the propagation light converted by the scatter at the exit side end portion of the opening are absorbed inside the resist, the intensity is attenuated.

On the other hand, at the approximately middle position B-B' between the openings, as coming away from the position z=0 (first surface), the light intensity once increases from zero and, after elapsing a peak value, it is attenuated.

In the formation of an optical latent image in a resist, by taking a large difference in light intensity between an irradiated portion and a non-irradiated portion, namely, by taking a large contrast between them, a produced pattern can have a sharp edge. Comparing the opening portion and the middle portion between the openings, a largest contrast is defined at a position z=0, that is, on the first surface.

On the other hand, in order to obtain large process latitude for a post-process, it is necessary to make the resist film thickness large as much as possible. It is seen from the above that, in accordance with the principle of near field exposure method of the present invention, regarding the value of resist film thickness, a value which is smaller than the z value (i.e. zl) where the curve B-B' shows a peak, in the graph of Figure 6B, can be chosen.

As regards the SPP wave, if the propagation surface has surface unevenness, it is scattered and thus attenuated easily. On the other hand, if the surface is smooth, the wave is not scattered and can be propagated through a long distance.

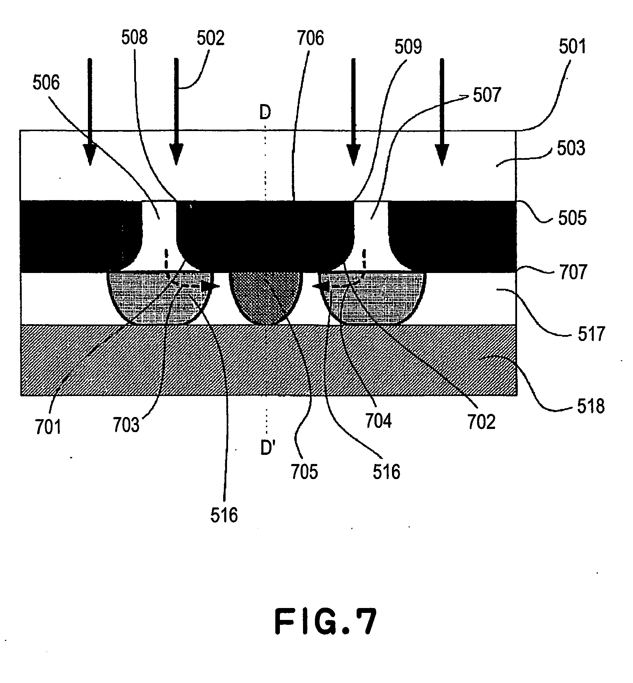

In consideration of this, as shown in Figure 7, a light exit side end portion 701 (702) of an opening formed in a light blocking metal film 706 is, according to an embodiment of a near-field exposure mask of the present invention, provided with a curved-surface structure, without a sharp edge. This is very effective to reduce scatter of a SPP wave 703 (704) at the light exit side edge portion. As a result, a conversion component to propagation light, due to the scatter at the light exit side edge portion, is reduced, such that the component of SPP wave 703 (704) going around to the first surface 707 side of the metal film 706 and being propagated along that surface increases. This results in that the region of a portion 705 where the light intensity is approximately zero, which portion is formed adjacent the first surface and approximately at the middle of adjacent openings, is extended in a direction of a normal to the first surface. Thus, the contrast can be improved thereby.

The advantageous effects of the present invention are attainable on the basis of using a portion where the light intensity is approximately zero, but also they are obtainable by using a portion having a lowered light intensity.

A curve D-D' in the graph of Figure 6B illustrates the relationship of the light intensity, at an approximately middle position D-D' between the openings (Figure 7), versus the distance z from the first surface of the metal thin film. It is seen that in the curve D-D' for a near-field exposure method according to the present invention, as compared with the curve B-B', the value of z that takes the peak level is shifted to z2 which is larger than zl. In such occasion, regarding the value of resist film thickness, in the graph of Figure 6B, a value which is smaller than the z value that takes a peak in the curve D-D', namely, a value smaller than z2, may be chosen.

If the resist film thickness thus chosen is insufficient in the point of height or durability, in subsequent processes for processing the substrate, a buffer layer may be formed between the substrate and the resist. The buffer layer may be a resist layer, an oxide film layer, or a metal layer, for example, not processed or, alternatively, processed so as to provide a physical property different from an image forming layer, such as, for example, hard baking or non-silylating in a case where a surface imaging method (e.g. multilayer resist method or surface layer silylating method), for example, is used. The buffer layer may be a single layer or it may comprise plural layers. By transferring a pattern, having been formed in an image forming layer on the basis of near field exposure, to the buffer layer in accordance with a method such as dry etching method, for example, one having a thickness sufficiently durable to the processing to be made to the substrate can be produced.

Separation of the near-field exposure mask from the resist and substrate after completion of the near field exposure, is performed as follows.

In Figure 2, the pressure adjusting means 213 is used to make the inside pressure of the pressure adjusting vessel 205 lower than the outside atmospheric pressure, to peel the metal thin film 203 of the near field exposure mask 201 off the resist 207 surface of the substrate 206. Where the pressure is reduced in this manner to perform separation of the mask 201 from the resist 207 and the substrate 206, in accordance with the Pascal's principle, the attracting force acting on between the front surface of the mask 201 and the resist 207 surface on the substrate 206 becomes uniform. As a result, there is no possibility that a large force is locally applied to the mask 201 or the resist 207 of the substrate 206, such that local breakage of the mask 201, the resist 207 or the substrate 206 during the separation can be prevented effectively.

Here, by adjusting the pressure inside the pressure adjusting vessel 205, the attracting force acting on between the mask 201 and the resist 207 and substrate 206, that is, the tensile force between them, can be controlled. For example, if the adhesion force between the mask surface and the resist and substrate surface is large, the pressure inside the pressure adjusting vessel may be set to a lower level to thereby increase the tensile force, to make the separation easier.

As described hereinbefore, as the pressure application structure for intimate contact, the structure may be reversed as compared with the Figure 2 structure, and the front surface of the near-field mask as well as the resist and the substrate may be disposed inside a reduced pressure vessel, so that, on the basis of a pressure difference with respect to the atmospheric pressure which is higher than the inside pressure of the reduced pressure vessel, a pressure may be applied to the mask from its rear surface side to the front surface side. In that occasion, for conducting the separation, the inside pressure of the vessel may be made higher than the outside atmospheric pressure.

Anyway, for separation, such a pressure difference that the pressure at the rear surface side of the exposure mask is lower than that at the front surface side, may be produced.

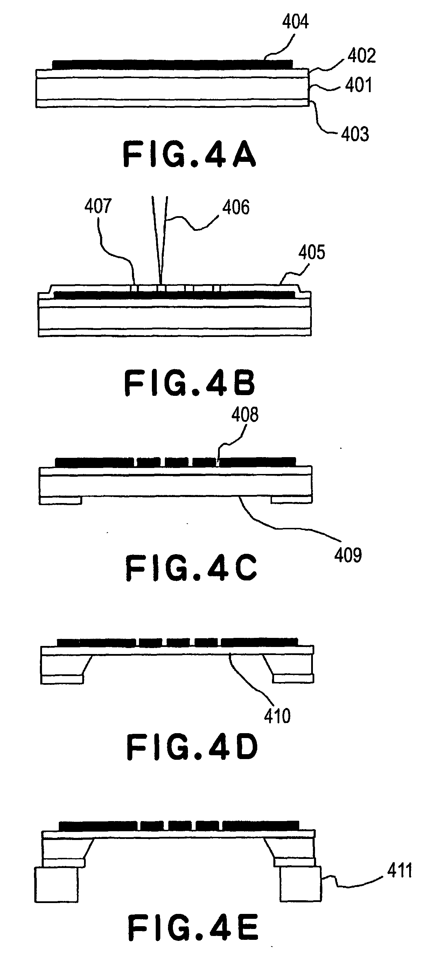

Next, the manner of producing a near-field exposure mask will be described in detail, in conjunction with Figures 4A - 4E.

As shown in Figure 4A, a substrate 401 of Si(100) having a thickness 500 µm and having polished surfaces at its opposite sides is processed in accordance with an LP-CVD method, whereby a Si₃N₄ film 402 for a mask base material and a Si₃n₄ film 403 for an etching window are produced, with a film thickness 2 pm, upon the front surface (upper surface in Figure 4) and the rear surface (lower surface in Figure 4) of the substrate, respectively. Thereafter, while conducting the control through film thickness monitoring, using a crystal oscillator, a Cr thin film 404 as a metal thin film for forming a fine opening pattern therein is produced on the Si₃N₄ film 402 at the front surface, by a vapor deposition method and with a film thickness of 50 µm.

Subsequently, a resist material 405 for electron beam is applied to the surface, and a pattern 407 having a width 10 nm is drawn thereon by use of an electron beam 406 (Figure 4B). Then, a developing process is carried out and, thereafter, an etching process is performed, whereby a fine opening pattern 408 is formed in the Cr thin film 404 (Figure 4C).

Subsequently, a window 409 for etching process is formed in the Si₃N₄ film 403 at the rear surface (Figure 4C), and an anisotropic etching is performed to the Si substrate 401 from its bottom surface by use of KOH, whereby a thin film-like mask 410 is produced (Figure 4D).

Finally, it is adhered to a mask supporting member 411, whereby a near-field exposure mask is produced (Figure 4E).

The process of forming the fine opening pattern 408 in the Cr thin film 404 uses an electron beam. However, in place of such electron beam processing, converging ion beam processing method, X-ray lithographic method, or scanning probe microscope (SPM) processing method may be used. Particularly, where a processing method based on SPM technology as can be represented by near-field optical microscope (SNOM), atomic force microscope (AFM), or scanning tunnel microscope (STM), is used to form the fine opening pattern, an extraordinarily fine opening pattern not greater than 10 nm can be provided. Thus, such methods are quite suitable to be used with the present invention.

In the embodiments described above, the mask base material is formed into a thin film shape so that it can follow the resist surface shape through elastic deformation, such that the whole surface of the mask can be brought into intimate contact with the resist surface.

If the surface of the metal thin film 402 to be contacted to the resist and substrate is not flat, the contact between the mask and the resist and substrate is insufficient, and it results in exposure unevenness. For this reason, as regards the magnitude of the surface irregularity of the metal thin film 402, strict flatness is required such as of an order of at least not greater than 100 nm, preferably, not greater than 10 nm.

Here, the width of the fine opening pattern may be smaller than the wavelength of light used for the exposure, and it may correspond to a desired pattern exposure width to be made to a resist. More specifically, a value may be desirably chosen out of a range 1 - 100 nm. Where the fine opening pattern is not less than 100 nm, not only the near field light to which the present invention pertains but also direct propagation light having a larger intensity would be transmitted through the mask. Therefore, it is necessary to take into account the influence of such direct propagation light.

While the width of the fine opening pattern should be not greater than 100 nm, there is no restriction in regard to the lengthwise direction, and any desired pattern can be chosen. For example, an L-shaped pattern such as shown in Figure 1A may be chosen and, alternatively, an S-shaped pattern (not shown) may be chosen.

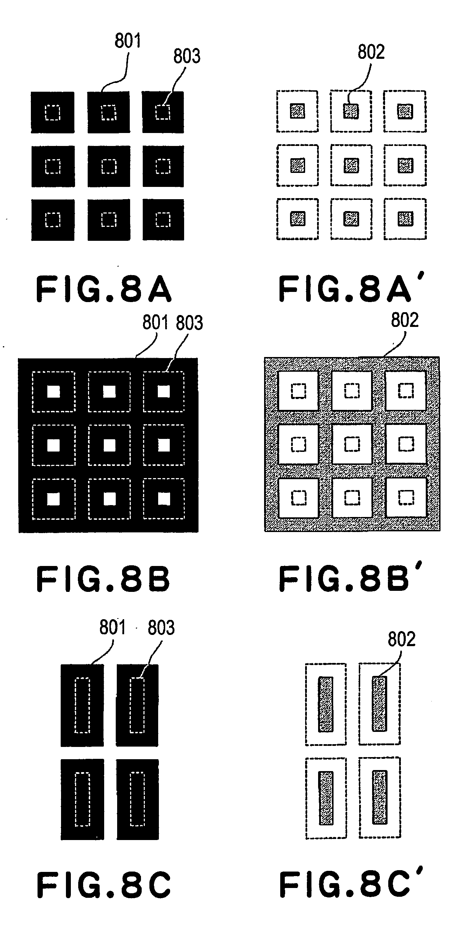

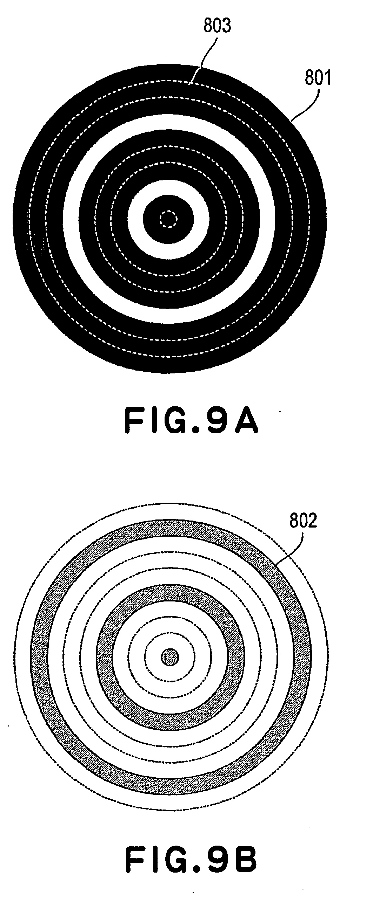

Where a mask having any one of a variety of two-dimensionally shaped mask patterns 801 such as shown in Figures 8 and 9 is applied to a near-field exposure mask of the present invention, just underneath the mask a latent image of two-dimensional shape such as illustrated at 803 is produced. After exposure development, a resist pattern 802 corresponding to it is produced.

For example, with a mask pattern having grid-like fine openings (Figure 8A), a two-dimensional dot array (in the case of positive type resist) such as shown in Figure 8A' or a hole array (in the case of negative type resist) is obtainable. These patterns may be suited for production of a two-dimensionally arrayed quantum dot array to be used for an optical device or electronic device having quantum dots.

On the other hand, with a mask pattern having a two-dimensional fine-opening array such as shown in Figure 8B, a two-dimensional grid-like array (in the case of positive type resist) such as shown in Figure 8B' or a hole array (in the case of negative type resist) is obtainable.

In the case of a mask pattern wherein a light blocking metal film portion has a two-dimensional rectangular array such as shown in Figure 8C, a two-dimensional fine-line pair (in the case of positive type resist) such as shown in Figure 8B' or a fine groove array (in the case of negative type resist) is obtainable. These patterns may be suited for production of a gate pattern to be used in a CMOS electronic device.

Further, in the case of a mask pattern wherein a light blocking metal film portion has a ring-like shape, such as shown in Figure 9A, a two-dimensional dot or ring array (in the case of positive type resist) such as shown in Figure 9B or a hole or ring array (in the case of negative type resist) is obtainable.

As regards the substrate 206 to be processed, which is going to be incorporated into a near-field exposure apparatus of this embodiment, anyone may be chosen from a wide variety of materials such as a semiconductor substrate such as Si, GaAs or InP, for example, an insulative substrate such as glass, quarts or BN, for example, and one having a film of metal, oxide or nitride formed on such a substrate.

It should be noted that, in the near field exposure apparatus of this embodiment, the near-field exposure mask 201 and the resist 207 and substrate 206 should be closely contacted to each other with a clearance not greater than 100 nm, preferably, not greater than 10 nm, throughout the whole exposure region. Therefore, as regards the substrate, it is necessary to choose one having best flatness as much as possible.

Similarly, the surface of the resist 207 used in the present invention should have good flatness with small surface irregularity. Also, since the light leaking from the near-field exposure mask is attenuated as like an exponential function, as the distance from the mask increases. Thus, taking into account that exposure of the resist 207 is difficult to reach a depth greater than 100 nm and that light is spread into the resist as like scattered to cause extension of the exposure pattern width, the thickness of the resist 207 should be at least not greater than 100 nm, and furthermore, it should be thin as much as possible.

As regards the resist material and the coating method, it is seen from the above that the material and coating method should be chosen to assure a film thickness of at least not greater than 100 nm, preferably, not greater than 10 nm, as well as a resist surface irregularity of a magnitude at least not greater than 100 nm, preferably, not greater than 10 nm, that is, extraordinarily high flatness.

As an example for satisfying such condition, a resist material may be dissolved into a solvent thereby to decrease the viscosity as much as possible, and it may be applied with an extraordinarily thin and uniform thickness, through a spin coating method.

Another example of resist material coating method may be a Langmuir Blodgett (LB) method in which a laminated film of monomolecular films is formed on a substrate, by picking up a monomolecular film plural times onto the substrate, the monomolecular film being provided by floating amphipathic resist material molecules, having hydrophobic group, hydrophilic group and functional group in a single molecule, upon the water surface.

Alternatively, a self assemble monolayer (SAM) forming method in which a monomolecular film of optical resist material is formed on a substrate through physical attraction or chemical bonding of only a single molecular layer to the substrate within a liquid solvent or a gaseous phase, may be used.

Among these coating methods, since the LB method and SAM method each enables formation of an extraordinarily thin resist film with a uniform thickness, and yet with good surface flatness. Therefore, these are good resist coating methods very suitable for use with the near-field exposure apparatus of the present invention.

In the near field exposure, it is required that, throughout the entire surface of the exposure region, the clearance between the near-field exposure mask 201 and the resist 207 and substrate 206 is kept not greater than 100 nm and, yet, constant without unevenness. For this reason, as a substrate to be used in the near field exposure, a substrate that has been already processed by another lithographic process, that has a pattern with a surface step is already formed there and that has surface irregularity of a magnitude not less than 100 nm, would be inappropriate. Thus, for near-field exposure, a substrate having good flatness as much as possible, that is, a substrate not having been processed by many processes or a substrate at an initial stage of the process, is preferable. Thus, where the near field exposure process is to be performed in combination with other type of lithographic process, desirably the near field exposure process should be conducted first or earlier as much as possible.

In Figure 3, the intensity of the near field light 306 leaking from the fine opening pattern 305 on the near-field exposure mask is different with the size or spacing of the fine opening pattern 305. Therefore, if the mask has fine openings of different sizes, it directly results in unevenness in the degree of exposure made to the resist 308 and, thus, formation of a uniform pattern become difficult to accomplish. In order to avoid this, the width of the fine opening pattern on the near-field exposure mask used in a single near-field exposure process - should be adjusted.

Although the foregoing description has been made to examples wherein a near-field exposure mask corresponding to the whole surface of a substrate is used and the near-field exposure is conducted to the whole surface of the substrate at once, the present invention is not limited to it. The present invention is applicable also to a step-and-repeat type exposure apparatus, and a near-field exposure mask smaller than a substrate may be used and the near field exposure to a portion of the substrate may be repeated while changing the exposure position on the substrate.

While the invention has been described with reference to the structures disclosed herein, it is not confined to the details set forth and this application is intended to cover such modifications or changes as may come within the scope of the following claims.

## Claims

1. An exposure method, comprising
placing a first surface of a light blocking member (706) having a plurality of openings (506, 507) formed in a mutually adjoining relation at an exposure object side (707),
projecting light (502) to the light blocking member (706) from a second surface side of the light blocking member (706) so that exposure of the exposure object (518) is carried out on the basis of near field light (516) leaking from the openings (506, 507), **characterized by**
causing interference between surface plasmon polariton waves (703, 704) passing respectively through adjacent openings (506, 507) and going around to the first surface side so that, on the basis of it, a portion having a decreased light intensity is produced in the exposure object (518) so that the exposure is carried out by use of the decreased light intensity portion, and
providing an end portion of each of the openings (506, 507) at the exposure object side (707) with a structure effective to reduce scatter of a surface plasmon polariton wave (703, 704) going around to the exposure object side (707) of the light blocking member (706).

2. A method according to Claim 1, further comprising producing an optical latent image corresponding to a difference in contrast between the decreased light intensity portion and a portion where near field light (516) leaks from the opening in the exposure object (518).

3. A method according to Claim 1 or 2, wherein the exposure object (518) has a thickness which is smaller than a distance between (i) a position in the decreased light intensity portion where the intensity with respect to a direction of normal to the first surface is largest and (ii) an interface between the first surface and the exposure object (518).

4. A device manufacturing method **characterized by**:
an exposure step for exposing a processing object in accordance with an exposure method as recited in any one of Claims 1-3, wherein the processing object comprises a substrate to be processed and an exposure layer to be exposed; and
a processing step of performing a predetermined process to the processing object having been exposed by said exposure step.

5. A method according to Claim 4, wherein said exposure step includes a process for providing a buffer layer between the substrate of the processing object and the exposure layer thereof and for transferring an exposure pattern formed on the exposure layer to the buffer layer.

6. An exposure mask configured to carry out exposure of an exposure object (518) on the basis of near field light (516) leaking from a plurality of openings (506, 507) provided in a light blocking member (706) in a mutually adjoining relation,
wherein the spacing between adjacent openings (506, 507) is not greater than the wavelength of light (502) used for the exposure,
**characterized in that**
an end portion (701, 702) of the opening at the exposure object side (707) has a structure effective to reduce scatter of a surface plasmon polariton wave (703, 704) going around to the exposure object side (707) of the light blocking member (706).

7. An exposure mask according to Claim 6, wherein the end portion (701, 702) of the opening at the exposure object side (707) has a curved surface shape.

8. An exposure apparatus having light irradiation means and an exposure mask according to Claim 6 or Claim 7.

## Patentansprüche

1. Belichtungsverfahren mit den Schritten:
Anordnen einer ersten Oberfläche eines Lichtblockadeelementes (706) mit einer Vielzahl von Öffnungen (506, 507), die in einer zueinander benachbarten Beziehung ausgebildet sind, auf einer Belichtungsobjektseite (707), und
Projizieren von Licht (502) auf das Lichtblockadeelement (706) von der Seite einer zweiten Oberfläche des Lichtblockadeelementes (706), so dass die Belichtung eines Belichtungsobjektes (518) auf der Grundlage von aus den Öffnungen (506, 507) austretendem Nahfeldlicht (516) ausgeführt wird,
**gekennzeichnet durch** die weiteren Schritte
Verursachen einer Interferenz zwischen Oberflächenplasmonpolaritonenwellen (703, 704), die jeweils **durch** benachbarte Öffnungen (506, 507) hindurchgehen und um die erste Oberflächenseite herumlaufen, so dass auf dieser Grundlage ein Abschnitt mit verringerter Lichtintensität in dem Belichtungsobjekt (518) erzeugt wird, und somit die Belichtung unter Verwendung des Abschnitts mit verringerter Lichtintensität ausgeführt wird, und
Versehen eines Endabschnittes jeder der Öffnungen (506, 507) auf der Belichtungsobjektseite (707) mit einer Struktur, die zur Reduktion der Streuung einer um die Belichtungsobjektseite (707) des Lichtblockadeelementes (706) herumlaufenden Oberflächenplasmonpolaritonenwelle (703, 704) wirksam ist.

2. Verfahren nach Anspruch 1, ferner mit dem Schritt:
Erzeugen eines optisch latenten Bildes entsprechend einer Differenz im Kontrast zwischen dem Abschnitt mit verringerter Lichtintensität und einem Abschnitt, wo das Nahfeldlicht (516) aus der Öffnung in dem Belichtungsobjekt (518) austritt.

3. Verfahren nach Anspruch 1 oder 2, wobei das Belichtungsobjekt (518) eine Dicke aufweist, die kleiner als ein Abstand zwischen (i) einer Position in dem Abschnitt mit verringerter Lichtintensität, wo die Intensität bezüglich der Richtung einer Normalen zu der ersten Oberfläche am Größten ist, und (ii) einer Grenzfläche zwischen der ersten Oberfläche und dem Belichtungsobjekt (518) ist.

4. Vorrichtungsherstellungsverfahren, **gekennzeichnet durch**:
einen Belichtungsschritt zur Belichtung eines Verarbeitungsobjekts gemäß einem Belichtungsverfahren nach einem der Ansprüche 1 bis 3, wobei das Verarbeitungsobjekt ein zu verarbeitendes Substrat und eine zu belichtende Belichtungsschicht aufweist; und
einen Verarbeitungsschritt zur Durchführung eines vorbestimmten Vorgangs an dem Verarbeitungsobjekt, das durch den Belichtungsschritt belichtet worden ist.

5. Verfahren nach Anspruch 4, wobei der Belichtungsschritt einen Vorgang zur Bereitstellung einer Pufferschicht zwischen dem Substrat des Verarbeitungsobjekts und dessen Belichtungsschicht sowie zur Übertragung eines auf der Belichtungsschicht ausgebildeten Belichtungsmusters auf die Pufferschicht umfasst.

6. Belichtungsmaske, die für die Ausführung eines Belichtungsvorgangs an einem Belichtungsobjekt (518) auf der Grundlage von Nahfeldlicht (516) eingerichtet ist, das aus einer Vielzahl von Öffnungen (506, 507) austritt, welche in einem Lichtblockadeelement (706) in einer zueinander benachbarten Beziehung bereitgestellt sind,
wobei der Abstand zwischen benachbarten Öffnungen (506, 507) nicht größer als die für die Belichtung verwendete Lichtwellenlänge (502) ist,
**dadurch gekennzeichnet, dass**
ein Endabschnitt (701, 702) einer Öffnung auf der Belichtungsobjektseite (707) eine Struktur aufweist, die zur Reduktion der Streuung einer um die Belichtungsobjektseite (707) des Lichtblockadeelementes (706) herumlaufenden Oberflächenplasmonpolaritonenwelle (703, 704) wirksam ist.

7. Belichtungsmaske nach Anspruch 6, wobei der Endabschnitt (701, 702) der Öffnung auf der Belichtungsobjektseite (707) eine gekrümmte Oberflächenform aufweist.

8. Belichtungsgerät mit einer Lichtbestrahlungseinrichtung und einer Belichtungsmaske gemäß Anspruch 6 oder Anspruch 7.

## Revendications

1. Procédé d'exposition, comprenant
la mise en place d'une première surface d'un élément (706) arrêtant la lumière ayant de multiples ouvertures (506, 507) formées dans une relation de jonction mutuelle du côté (707) d'un objet d'exposition,
la projection de lumière (502) sur l'élément (706) d'arrêt de la lumière depuis un second côté de surface de l'élément (706) d'arrêt de la lumière afin qu'une exposition de l'objet d'exposition (518) soit effectuée sur la base de lumière de champ proche (516) fuyant des ouvertures (506, 507), **caractérisé par**
la création d'une interférence entre des ondes (703, 704) de polariton de plasmon de surface passant respectivement à travers des ouvertures adjacentes (506, 507) et circulant vers le côté de la première surface afin que, sur la base de celle-ci, une partie ayant une intensité lumineuse diminuée soit produite dans l'objet d'exposition (518) afin que l'exposition soit effectuée par l'utilisation de la partie d'intensité lumineuse diminuée, et
le fait de pourvoir une partie extrême de chacune des ouvertures (506, 507) du côté (707) de l'objet d'exposition d'une structure ayant pour effet de réduire la dispersion d'une onde (703, 704) de polariton de plasmon de surface circulant vers le côté (707) de l'objet d'exposition de l'élément (706) d'arrêt de la lumière.

2. Procédé selon la revendication 1, comprenant en outre la production d'une image latente optique correspondant à une différence de contraste entre la partie d'intensité lumineuse diminuée et une partie où de la lumière (516) de champ proche fuit de l'ouverture dans l'objet (518) d'exposition.

3. Procédé selon la revendication 1 ou 2, dans lequel l'objet d'exposition (518) a une épaisseur qui est inférieure à une distance entre (i) une position dans la partie d'intensité lumineuse diminuée où l'intensité par rapport à la direction d'une normale à la première surface est la plus grande et (ii) une interface entre la première surface et l'objet (518) d'exposition.

4. Procédé de fabrication d'un dispositif, **caractérisé par** :
une étape d'exposition consistant à exposer un objet de traitement conformément à un procédé d'exposition selon l'une quelconque des revendications 1 à 3, dans lequel l'objet de traitement comporte un substrat devant être traité et une couche d'exposition devant être exposée ; et
une étape de traitement consistant à exécuter un traitement prédéterminé sur l'objet de traitement ayant été exposé par ladite étape d'exposition.

5. Procédé selon la revendication 4, dans lequel ladite étape d'exposition comprend un traitement pour former une couche tampon entre le substrat de l'objet de traitement et sa couche d'exposition et pour transférer à la couche tampon un motif d'exposition formé sur la couche d'exposition.

6. Masque d'exposition configuré pour effectuer l'exposition d'un objet (518) d'exposition sur la base d'une lumière (516) de champ proche fuyant de multiples ouvertures (506, 507) situées dans un élément (706) d'arrêt de la lumière dans une relation de jonction mutuelle,
dans lequel l'écartement entre des ouvertures adjacentes (506, 507) n'est pas supérieur à la longueur d'onde de la lumière (502) utilisée pour l'exposition,
**caractérisé en ce que**
une partie extrême (701, 702) de l'ouverture du côté (707) de l'objet d'exposition a une structure ayant pour effet de réduire la dispersion d'une onde (703, 704) de polariton de plasmon de surface circulant vers le côté (707) de l'objet d'exposition de l'élément (706) arrêtant la lumière.

7. Masque d'exposition selon la revendication 6, dans lequel la partie extrême (701, 702) de l'ouverture du côté (707) de l'objet d'exposition a une forme de surface courbe.

8. Appareil d'exposition ayant un moyen d'irradiation de lumière et un masque d'exposition selon la revendication 6 ou la revendication 7.
